# EUROPEAN PATENT SPECIFICATION

(11) **EP 1 642 998 B1**
(45) Date of publication and mention of the grant of the patent: **14.12.2011**
(21) Application number: 04746626.3
(22) Date of filing: 29.06.2004
(51) Int. Cl.: C23C 14/32, B23B 27/14, B23B 51/00, B23P 15/28

(54) **PRODUCTION DEVICE FOR MULTIPLE-SYSTEM FILM AND COATING TOOL FOR MULTIPLE-SYSTEM FILM**
VORRICHTUNG ZUR HERSTELLUNG VON MEHRSYSTEMFILM UND AUFTRAGSWERKZEUG FÜR MEHRSYSTEMFILM
DISPOSITIF DE PRODUCTION POUR FILM A MULTIPLES SYSTEMES ET OUTIL DE REVETEMENT POUR FILM A MULTIPLES SYSTEMES

(30) Priority: 30.06.2003 JP 2003187057
(43) Date of publication of application: 05.04.2006
(73) Proprietor: Nachi-Fujikoshi Corp., Toyama-shi, Toyama 930-8511 (JP)
(72) Inventor: SATO, Hideki, Toyama-shi, Toyama 9300964 (JP); KITAJIMA, Kazuo, Toyama-shi, Toyama 9398006 (JP); SONOBE, Masaru, Nakaniikawa-gun, Toyama 9300284 (JP); KATO, Norihiro, Toyama-shi, Toyama 9318328 (JP); YASUOKA, Manabu, Toyama-shi, Toyama 9398192 (JP)
(74) Representative: Henkel, Breuer & Partner
(86) International application number: PCT/JP2004/009157
(87) International publication number: WO 2005/001153

(56) References cited:
- WO-A-99/14392
- JP-A- 2 101 160
- JP-A- 3 193 868
- JP-A- 6 264 225
- JP-A- 62 211 376
- JP-A- 2001 001 202
- JP-A- 2002 212 712
- JP-U- 6 065 466
- US-A- 4 877 505
- US-A- 5 208 102
- US-A- 5 246 787
- US-A- 5 250 779
- US-A- 5 709 784
- KIMURA A, ET AL.: 'Hot-pressed Ti-Al targets for synthesizing Ti1-xAlxN films by the arc ion plating method' THIN SOLID FILMS vol. 382, 2001, pages 101 - 105, XP002903405

## Description

### TECHNICAL FIELD

The present invention relates to a production method which can more easily produce a nitride, a carbide, a boride, an oxide or a silicide containing two or more metal components such as TiAlN than prior art.

### BACKGROUND ART

A PVD (Physical Vapor Deposition) method has been known as a method of coating a product surface to give it abrasion resistance, oxidation resistance, corrosion resistance and other some functions.
An ion plating method, which is used as one of the PVD method and combines one part of a vacuum deposition method with a sputtering process, is a surface treatment method for forming a coating of a metal compound such as a metal carbide, a metal nitride and a metal oxide or a compound thereof. This method is now significant as the method of coating particularly the surface of a sliding member and a cutting tool.

Conventionally, a nitride containing two or more metal components such as a TiAlN film has been exclusively produced by an arc process or a sputtering process.
However, these methods need an expensive alloy target serving as a vaporizing material and need to prepare the target of a composition according to an objective film composition. Further, the methods hardly use the whole of a raw material, by reason of an electromagnetic field and a holding method of the target. In addition, the arc process inevitably involves deposition of unreacted metal droplets and can not form a film with satisfactory quality. The sputtering process can form an extremely flat film, but has generally a small film-forming rate.

On the contrary, a melting-evaporation type ion plating method (hereafter referred to as a melting method), has an advantage of evaporating most of a charged raw material and a high material use efficiency. This is particularly advantageous when using a metal of high material unit cost or a hardly formable metal as the raw material. However, the conventional melting method has difficulty in uniformly evaporating two or more sorts of metal materials with remarkably different melting points.

For instance, when two or more sorts of metal elements with largely different melting points such as Ti and Al are melted in the same crucible with a conventional method, Al with a low melting point precedently melts and vaporizes, and subsequently Ti does. As a result, the obtained film has a composition affected by the difference of the melting points, specifically contains a high ratio of the low-melting metal on a base metal side, and contains gradually a high ratio of the high-melting metal toward a surface layer.
Thus, the film containing two or more sorts of metal elements formed with the conventional method has a distributed composition wholly depending on their melting points, and accordingly has had difficulty in controlling the composition distribution in a film thickness direction. It was almost impossible to control the film on the base metal side so as to contain a higher ratio of the high-melting metal, and the film on the surface side so as to contain a higher ratio of the low-melting metal.

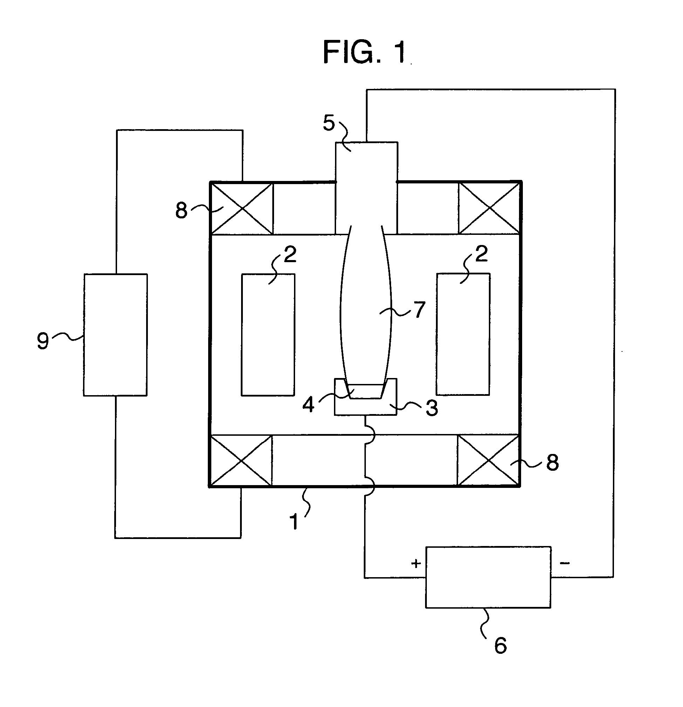

In order to solve such a problem, a method of installing a plurality of evaporation sources in an ion plating apparatus has been adopted, for instance, as seen in JP-U-06-33956 (Fig. 1).
However, in order to provide the plurality of evaporation sources, the ion plating apparatus needs an additional power supply. Further, In addition, a film-forming rate by the melting method depends on a distance or positional relation of the evaporation source from or with an article to be vapor-deposited, but it is difficult for the apparatus having the plurality of evaporation sources to uniformize the positional relationship between the plurality of evaporation sources and the article to be vapor-deposited. For this reason, it is almost impossible to obtain a film having a consistent composition.

### DISCLOSURE OF THE INVENTION

### PROBLEM TO BE SOLVED BY THE INVENTION

Accordingly, it is desired to form a multicomponent film containing metal components such as TiAIN having greatly different melting points in adequate quality, for instance, in which each component of different metals is distributed at a desired rate over the whole film thickness. It is also preferable to form the film at high material use efficiency by using a raw material alloy which has metal components not required to be strictly matched with an objective film composition but almost close to the objective film composition, and of which the whole part can be effectively used.
The invention has an object of providing a production method for forming such a multicomponent film.

### MEANS FOR SOLVING THE PROBLEM

A multicomponent film production method according to the invention has the features of the claim and uses an alloy containing at least two sorts of metals or an intermetallic compound as a vaporizing raw material, melts and evaporates the material from a single crucible or hearth with the use of plasma converged by an electric field or a magnetic field. At this time, an unmelted portion of the raw material is sequentially melted and evaporated by supplying first electric power necessary for melting and evaporating the material and by supplying electric power while gradually increasing the power at predetermined intervals repeatedly up to the necessary maximum electric power. Further, the plasma is converged in a first plasma region necessary to evaporate the raw material and is subsequently and sequentially moved and expanded from the first plasma region to the maximum plasma region and then, sequentially melts and evaporates an unmelted portion of the raw material.

The above scheme allows a melted portion to be expanded during coating treatment for supplementing the metal of a low melting point.
As a result, it is possible to form a film in adequate quality, in which respective metal components with greatly different melting points of a metal such as TiAlN form a desired composition distribution over the whole film thickness by controlling the composition of a starting raw material and the melting rate of an unmelted portion. The vaporizing raw material does not need to be strictly matched with an objective film composition and may be an alloy having a metal composition approximately close to the objective film composition. Furthermore, almost the whole material can be effectively used and the material use efficiency is high.

A coated tool according which has a cutting tool base material such as a high-speed tool steel, a die steel, a cemented carbide or a cermet, and the film of a nitride, a carbide, a boride, an oxide or a silicide containing a plurality of metal elements can be formed on the base material by the above method according to the invention.
Thus, the coated tool with the superior film having desired composition distribution can be obtained.

### MODE FOR CARRYING OUT THE INVENTION

The invention will be now described in detail with reference to an embodiment. At the outset, the development to the invention will be described.
The present inventors attempted to form a TiAlN film under a condition of obtaining a general TiN coating with the use of 50 g of a TiAl alloy as a melting raw material. In this attempt, the TiAl alloy was totally melted in a few minutes after having started melting. The film thus obtained had a composition in which Al was abundant on a base material side and Ti was gradually abundant toward a surface side. This is because Al has a lower melting point than Ti and precedently vaporizes from the melted material, so that the film formed at first inevitably contains a high ratio of A1.

When the coating process was further continued, Al in the raw material was exhausted and the film containing a high ratio of Ti was formed at the outermost. Thus obtained film had a low hardness and poorer adhesiveness as compared with a TiN film.
Then, the inventors considered supplying A1 which was exhausted by evaporation, and conducted experiments of additionally charging Al into a melted material. However, it was difficult to balance melting and evaporation with the Al supply, and a satisfactory result was not obtained.

According to the conventional technique, it is general to control electric power used for melting a raw material to approximately constant electric power determined to be optimum at first, except when starting melting.
The inventors inferred that if the electric power was increased in a stepped manner at predetermined intervals during the melting, an unmelted portion would newly start melting and supplement a low-melting metal contained in the unmelted portion to the film. They repeated many experiments and could prove correctness of the inference.

Furthermore, according to the conventional technique, also in melting an unmelted portion by controlling an electric field or a magnetic field for converging plasma, it is general to control a plasma region used for melting a raw material to an approximately constant plasma region determined to be optimum at the beginning, except when starting melting.
The inventors inferred that a similar effect would be obtained by controlling the plasma so that the plasma region was continuously moved and expanded from the first region up to the maximum plasma region by sequentially moving and expanding the plasma. They repeated many experiments and could prove correctness of the inference.

The present invention is based on such knowledge of the inventors as the above.
A production device for carrying out the method according to the embodiment of the invention uses an alloy containing at least two sorts of metals or intermetallics compound as a vaporizing raw material, melts and evaporates the raw material to form a multicomponent film. The production device has, as shown in Fig. 1, a vacuum chamber 1 for accommodating a member to be coated or a workpiece 2, and a single crucible or hearth 3 mounted in the chamber for receiving the raw material 4. The device is further equipped with a power supply unit 6 including a HCD gun (Hollow Cathode Gun) 5, which supplies an electric power to the crucible to cause arc discharge, evaporates and ionizes the raw material by the generated heat and plasma 7, and a plasma control unit 9 including an electromagnetic coil 8 for controlling a magnetic field for converging the plasma when evaporating the raw material.

The production device for carrying out the method of the embodiment may have the same construction as the conventional apparatus according to the melting and evaporating type ion plating method, except the power supply unit 6 and the plasma control unit 9, and further description on the same components will be omitted.
The electric power supply unit 6 is on a sequentially-increased electric power supply system of gradually increasing electric power to be supplied and sequentially melting the unmelted portion of a raw material.
In this embodiment, the electric power supply unit 6 first supplies electric power of 2,000 W necessary for evaporating the raw material. Then, the unit supplies electric power increased by 300 W from the electric power supplied immediately before at an predetermined interval of one minute. The electric power increased by 300 W is thus repeatedly supplied up to the necessary maximum electric power of 8,000 W, and sequentially melts the unmelted portion.

The plasma control unit 9 similarly has a construction of changing the magnetic field control for converging the plasma when evaporating the raw material.
In the embodiment, the plasma control unit 9, at first, converges the plasma in a first plasma region necessary for evaporating the raw material, or a region with a diameter of 10 mm about an approximate center of the material. After that, the unit controls the plasma so as to sequentially move and expand it from the immediately preceding plasma region. The plasma is thus continuously and sequentially moved and expanded up to the maximum plasma region with a diameter of 40 mm almost covering the whole material, and sequentially melts the unmelted portion.

Examples of tools with films formed by the method according to the invention will be described below.

### [Example 1]

As a vaporizing raw material, a TiAl alloy plate having a diameter of 40 mm, which contained metal compounds almost similar to an objective film composition, was used. The material was charged into the crucible (or hearth), the workpiece was heated and cleaned, and then, the raw material was melted and evaporated in a mixture atmosphere of argon and nitrogen gases at a pressure of about 1 Pa. At this time, a HCD gun was used, which was set to converge the diameter of a plasma beam into about 10 mm on the top face of the raw material to be melted. A TiAIN film was formed from thus obtained vapor of the raw material on a high speed steel drill and a cemented carbide end mill which had a TiCN coating beforehand coated as an undercoat.

A plasma output at this time was increased by 300 W per minute from 2,000 W to 8,000 W for 20 minutes. At the same time, the plasma control was performed so as to continuously and sequentially move and expand the diameter of the plasma beam for 20 minutes to finally cover the whole TiAlN alloy plate with the diameter of about 40 mm ultimately and to sequentially melt the unmelted portion.
The result of a cutting test with the obtained high speed steel drill is shown in Table 1 (item name: drill life). The test was conducted to use the high speed steel drill in cutting up to the breakage life.

### (Cutting condition of the high speed steel drill)

tool: high speed steel drill of φ6
cutting method: drilling, using 5 pieces of each example
work material: S50C (hardness 210 HB)
cutting speed: 40 m/min, feed: 0.1 mm/rev
cutting length: 20 m (through hole), lubricant: dry type (none)

**[Table 1]**

| | Film thickness * µm | Film hardness HV0.05 | Drill life (hole) | End mill flank wear V_{B} (mm) | Oxidiza tion thickness µm | |
|---|---|---|---|---|---|---|
| TiCN+TiAlN (melting method) | Surface layer 0.9 Undercoat 1.7 | 3300 | 852 | 0.05 | 0.4 | Invention |
| TiCN (melting method) | 2.1 | 2800 | 416 | 17m stopped | All oxidized | Comparative example |
| TiCN+TiAlN (arc prosess) | Surface layer 1.2 Undercoat 1.9 | 3800 | 489 | 0.08 | 0.6 | Comparative example |

| | | | | | | |
|---|---|---|---|---|---|---|
| * Film thicknesses are values measured on simultaneously installed test pieces of high speed steel (SKH51, Ra≤0.2 µm) with a carotest method (fretting mark method). | | | | | | |

As is apparent from Table 1, the high speed steel drill with the hard film according to the invention shows the very long life almost twice as compared with the conventional examples. This is because the melting method forms almost no droplet and imparts small surface roughness.
According to the invention, the multicomponent film containing metal components with greatly different melting points such as TiAlN had such adequate film quality as to show the desired distribution of the respective, different metal components over the whole film thickness. Further, as for the vaporizing raw material, since it does not need to strictly match with the objective film composition, a raw alloy material having metal compounds approximately close to the objective film composition may be used and almost the whole parts of the material can be effectively used so that the material use efficiency is high.

### [Example 2]

Cemented carbide inserts (A30) were coated under the condition of Example 1 and were heated to and held at 900°C for one hour in atmospheric air. The result of measuring the thicknesses of surface oxide layers of the inserts is jointly written in Table 1 (item name: oxidization thickness). It is understood that since the film has less film defects such as droplets as compared with that according to the arc process (the conventional example), progression of oxidation is slow and the thickness of an oxidized layer is small (improves oxidation resistance).

### [Example 3]

A cemented carbide end mill previously coated with a TiCN film in the condition of Example 1 was coated with a TiAlN film. A wear width in the flank of the cemented carbide end mill was measured after it had cut the length of 40 m, and the result is written together in Table 1 (item name: end mill flank wear). Cutting conditions are shown below.

### (Cutting condition of cemented carbide end mill)

tool: φ10 cemented carbide square end mill with two cutting edges
cutting method: downward side cutting
work material: SKD61 (hardness 53 HRC)
depth of cut: 10 mm in axial direction and 0.2 mm in diametrical direction
cutting speed: 314 m/min, feed: 0.07 mm/edge
cut length: 40 m, lubricant: none (air blow)
The cemented carbide end mill showed abrasion resistance about 10% better than a TiAlN film formed by the arc process and provided the excellent TiAlN film. Because the films have the same content, it is considered that the improvement of the oxidation resistance by reduction of droplets contributes to this result.

### [Example 4]

Gear hobs were variously coated according to the claim in the condition of Example 1 and were used in dry type cutting under a condition of V=200 m/min, f=2.2 mm/rev and a cut length of 80 m. Table 2 shows the result of measuring wear amounts after the cutting. The gear hob coated with the TiAlN film formed by the melting method according to the invention is reduced in crater abrasion by about 30% and in flank wear by about 8% as compared with the TiAlN film formed by the arc process and showed extremely satisfactory abrasion resistance.

**[Table 2]**

| | Film thickness * µm | Crater wear KT (µm) | Flank wear V_{B} (µm) | |
|---|---|---|---|---|
| TiCN+TiAlN (melting method) | Surface layer 0.9 Undercoat 1.7 | 8 | 120 | Invention |
| TiCN+TiAlN (arc prosess) | Surface layer 1.2 Undercoat 1.9 | 12 | 130 | Comparative example |

| | | | | |
|---|---|---|---|---|
| * Film thicknesses are values measured on simultaneously installed test pieces of high speed steel (SKH51, Ra≤0.2µm) with a carotest method (fretting mark method). | | | | |

In the above, the invention has been described with reference to the embodiment, but the invention is not limited solely to this specific form, and the described form can be variously changed or the invention may take other forms within the scope of attached claims.
For instance, although a magnetic field is used for controlling the convergence of plasma in the embodiment, it is needless to say that an electric field may be used.

### BRIEF DESCRIPTION OF THE DRAWING

Fig. 1 is a schematic view showing the whole configuration of a multicomponent film production device for carrying out the method according to the embodiment of the invention.

## Claims

1. A method for producing a multicomponent film by using a vaporizing material (4) of an alloy containing at least two sorts of metals or intermetallics compound and by melting and evaporating the material from a single crucible or hearth (3) with use of plasma (7) converged by an electric field or a magnetic field, **characterized by**
supplying first electric power necessary for evaporating the material (4), and then supplying electric power increased stepwise from the first electric power at predetermined intervals repeatedly up to necessary maximum electric power to sequentially melt an unmelted portion of the material, and
converging the plasma (7) into a first plasma region necessary for evaporating the material (4), and then continuously and sequentially moving and expanding the plasma from the first plasma region up to a maximum plasma region to sequentially melt the unmelted portion.

## Patentansprüche

1. Ein Verfahren zum Herstellen eines Mehrkomponentenfilms durch Verwenden eines verdampfenden Materials (4) einer Legierung, die mindestens zwei Sorten von Metallen oder intermetallischen Verbindungen enthält, und durch Schmelzen und Verdampfen des Materials von einem einzelnen Tiegel oder Herd (3) unter Verwendung von Plasma (7), das durch ein elektrisches Feld oder ein magnetisches Feld konvergiert wird, **gekennzeichnet durch**
Zuführen von erster elektrischer Energie, die notwendig ist, um das Material (4) zu verdampfen, und dann Zuführen von elektrischer Energie, die von der ersten elektrischen Energie in vorbestimmten Intervallen wiederholt schrittweise bis zu der erforderlichen maximalen elektrischen Energie erhöht wird, um einen nichtgeschmolzenen Teil des Materials sequentiell zu schmelzen, und
Konvergieren des Plasmas (7) in einem ersten Plasmabereich, der erforderlich ist zum Verdampfen des Materials (4), und dann kontinuierliches und sequentielles Bewegen und Expandieren des Plasmas von dem ersten Plasmabereich bis zu einem maximalen Plasmabereich, um den nichtgeschmolzenen Teil sequentiell zu schmelzen.

## Revendications

1. Procédé de production d'un film à composants multiples en utilisant un matériau de vaporisation (4) d'un alliage contenant au moins deux sortes de métaux ou un composé intermétallique et en faisant fondre et en évaporant le matériau à partir d'un seul creuset ou foyer (3) en utilisant un plasma (7) convergé par un champ électrique ou un champ magnétique, **caractérisé en ce qu'**il comprend :
l'alimentation d'une première puissance électrique nécessaire pour évaporer le matériau (4), puis l'alimentation d'une puissance électrique accrue par incrément par rapport à la première puissance électrique à des intervalles prédéterminés à répétition jusqu'à une puissance électrique maximale nécessaire pour faire fondre séquentiellement une partie non fondue du matériau, et
la convergence du plasma (7) dans une première région de plasma nécessaire pour évaporer le matériau (4), puis continuellement et séquentiellement le déplacement et l'expansion du plasma à partir de la première région de plasma jusqu'à une région de plasma maximale pour faire fondre séquentiellement la partie non fondue.
